# EUROPEAN PATENT APPLICATION

(11) **EP 4 749 295 A1**
(43) Date of publication of application: **27.05.2026**
(21) Application number: 24843356.7
(22) Date of filing: 27.06.2024
(51) Int. Cl.: G01R 1/04, G01R 1/067, G01R 3/00, G01R 31/28

(54) **RUBBER SOCKET APPARATUS FOR TESTING CIRCUITS OF ELECTRONIC DEVICE**

(30) Priority: 20.07.2023 KR 20230094359; 13.12.2023 KR 20230180980
(71) Applicant: Belink Co., Ltd., Seongnam-si, Gyeonggi-do 13207 (KR); Sae Han Micro Tech Co., Ltd., Namyangju-si, Gyeonggi-do 12018 (KR)
(72) Inventor: PARK, Yeon Ho, Yongin-si, Gyeonggi-do 16994 (KR); PARK, Sang Young, Icheon-si, Gyeonggi-do 17372 (KR); LEE, Jeahyoung, Hwaseong-si, Gyeonggi-do 18441 (KR); KIM, Sukmin, Namyangju-si, Gyeonggi-do 12285 (KR); PARK, Juncheol, Uijeongbu-si, Gyeonggi-do 11800 (KR)
(74) Representative: Schaad, Balass, Menzl & Partner AG
(86) International application number: PCT/KR2024/008990
(87) International publication number: WO 2025/018636

(57) **Abstract**

Disclosed is a rubber socket apparatus for testing circuits of an electronic device, the apparatus having a shielding layer or a film that can remove signal noise. The rubber socket apparatus for testing circuits of an electronic device, according to one aspect of the present invention, may comprise: a plurality of test pins aligned so that circuits of an electronic device can be tested; a rubber layer in which the plurality of test pins are embedded upright; and a shielding film which is in close contact with either the upper surface or the lower surface of the rubber layer for shielding or signal noise reduction.

## Description

### TECHNICAL FIELD

The present invention relates to a rubber socket apparatus for testing circuits of an electronic device, and more specifically to a rubber socket apparatus for testing circuits of an electronic device having a shielding layer or a film that is capable of removing signal noise.

### BACKGROUND ART

In general, products formed with circuit patterns, such as semiconductor devices and flat panel displays (FPDs), essentially require a process of testing the electrical status of circuit patterns during the manufacturing process, and the device applied herein can be called a socket apparatus for testing circuits of an electronic device.

For example, a semiconductor device with an electrical circuit formed on a silicon wafer undergoes an Electrical Die Sorting (EDS) process to test electrical characteristics thereof, and a testing device can perform the EDS process by applying an electrical signal to a chip formed on a silicon wafer, obtaining an electrical signal output from the chip, and determining whether the chip is defective.

According to related art, sockets that are applied to sockets for semiconductor device testing are applied in a variety of products, such as pogo type, rubber type and injection molding plate type.

As semiconductor devices are developed into high-integration, low-power, and ultra-high-speed forms, complex responses from test socket apparatuses are required. They must be able to respond to fine pitch, high speed and high temperature, and the product lifespan must also be maintained to meet customer demands.

In the case of the pogo pin type, there is a physical limitation in responding to fine pitch due to the structure of a pogo pin. Therefore, there was a problem in that the unit price increased rapidly when miniaturization was performed.

Rubber type (PCR) had a problem in that there is a large difference in characteristics depending on the test temperature, and there was a problem in that when conducting a cold test of a fine pitch product, the characteristics were poor, and the lifespan was rapidly reduced.

The injection molding plate pin type had problems such as ball damage during ball package testing in the burn-in process.

Currently, rubber products using metal powder are mainly used in the fine pitch product group of the memory semiconductor product group, but there is a problem that many problems occur due to rapid reduction in lifespan in high and low temperature tests (Hot/Cold Test) of fine pitch products.

In addition, according to related art, there were problems in which contact was not properly made due to accumulated processing tolerances of structures that perform electrical contact in various ways and members such as pins installed in the structures.

In addition, according to related art, there was a problem that test failure occurred because shielding or signal noise was not removed well in rubber types and the like.

### DISCLOSURE

### TECHNICAL PROBLEM

The present invention has been devised to solve the above problems, and an object of the present invention is to provide a rubber socket apparatus for testing circuits of an electronic device, which can prevent test failures by applying a shielding layer or a film that is capable of removing signal noise among upper and lower parts of a rubber-type socket apparatus.

Another object of the present invention is to provide a rubber socket apparatus for testing circuits of an electronic device, which has a shielding layer or a film for removing signal noise that can also serve as a support for holding up a pin from an upper part or a lower part, when applying and manufacturing a metal pin or a MEMS pin.

The problems of the present invention are not limited to the problems mentioned above, and other problems that are not mentioned will be clearly understood by those skilled in the art to which the present invention pertains from the description below.

### TECHNICAL SOLUTION

According to one aspect of the present invention, provided is a rubber socket apparatus for testing circuits of an electronic device, including: a plurality of test pins aligned such that circuits of an electronic device are tested; a rubber layer in which the plurality of test pins are embedded upright; and a shielding film that is in close contact with any one surface of an upper surface or a lower surface of the rubber layer for shielding or signal noise reduction.

In this case, an upper film and a lower film may be bonded to upper and lower parts of the rubber layer, respectively, and any one of the upper film or the lower film may be the shielding film.

In this case, the shielding film may be a copper-plated film or a film embedded with a copper layer.

In this case, the plurality of test pins may be MEMS pins having an upper body, a lower body and an elastic connection portion configured to connect the upper body and the lower body.

In this case, a rubber layer that is penetrated by the plurality of test pins may not be supplied with a rubber material and remain empty.

In this case, a rubber layer that is penetrated by the plurality of test pins may be filled with a softer rubber material than other parts.

In this case, a rubber layer in which a lower body and an upper body of the MEMS pin are disposed may be filled with different rubber materials, wherein a rubber material filled in the upper body may be softer than a rubber material filled in the lower body.

In this case, an elastic connection portion of the MEMS pin may not be provided with a rubber material and may be formed with an air layer.

In this case, the shielding film may be made of an FR4 laminate film plated with copper or include a copper film internally.

In this case, the rubber layer may be made of a silicone rubber.

In this case, among the plurality of test pins, any one may be a ground pin, and the ground pin may be electrically connected to a copper plating or a copper film of the shielding film to remove signal noise.

### ADVANTAGEOUS EFFECTS

According to the above configuration, the rubber socket apparatus for testing circuits of an electronic device according to one aspect of the present invention can prevent test failures by applying a shielding layer or a film that is capable of removing signal noise among upper and lower parts of a rubber-type socket apparatus.

The rubber socket apparatus for testing circuits of an electronic device according to one aspect of the present invention can also serve as a support for holding up a pin from an upper part or a lower part when applying and manufacturing a metal pin or MEMS pin.

It should be understood that the effects of the present invention are not limited to the effects described above, but include all effects that can be inferred from the configuration of the invention described in the detailed description or claims of the present invention.

### DESCRIPTION OF DRAWINGS

FIG. 1 is a cross-sectional view of a rubber socket apparatus for testing circuits of an electronic device according to one embodiment of the present invention.
FIG. 2 is a perspective view of a MEMS pin, which is a partial component of a rubber socket apparatus for testing circuits of an electronic device according to one embodiment of the present invention.
FIG. 3 is a cross-sectional view showing a state before the testing of a rubber socket apparatus for testing circuits of an electronic device according to one embodiment of the present invention is performed.
FIG. 4 is a plan view of a rubber socket apparatus for testing circuits of an electronic device according to one embodiment of the present invention.
FIG. 5 is a partially enlarged cross-sectional view of a socket apparatus for testing circuits of an electronic component according to another embodiment of the present invention.

### MODES OF THE INVENTION

Hereinafter, with reference to the attached drawings, embodiments of the present invention will be described in detail so that those skilled in the art can easily practice the present invention. The present invention may be implemented in various different forms and is not limited to the embodiments described herein. In order to clearly describe the present invention, parts that are not related to the description are omitted in the drawings, and the same reference numerals are assigned to the same or similar components throughout the specification.

The words and terms used in the present specification and claims should not be construed as limited to their usual or dictionary meanings, but should be interpreted as having meanings and concepts consistent with the technical idea of the present invention, in accordance with the principles by which the inventor can define terms and concepts in order to best describe his or her invention.

Therefore, the embodiments described in the present specification and the configurations illustrated in the drawings correspond to preferred embodiments of the present invention and do not represent all of the technical ideas of the present invention, and therefore, the configurations may have various equivalents and modified examples that can replace them at the time of filing of the present invention.

In the present specification, it should be understood that terms such as "include" or "have" are intended to describe the presence of a feature, number, step, operation, component, part or combination thereof described in the specification, but do not exclude in advance the possibility of the presence or addition of one or more other features, numbers, steps, operations, components, parts or combinations thereof.

When a component is said to be "in front of," "behind," "above" or "below" another component, unless there are special circumstances, it includes not only being positioned "in front of," "behind," "above" or "below" the other component in direct contact with it, but also cases where there are other components intervening therebetween. In addition, when a component is said to be "connected" to another component, unless there are special circumstances, it includes cases where they are indirectly connected to each other as well as cases where they are directly connected to each other.

Hereinafter, a rubber socket apparatus for testing circuits of an electronic device according to an embodiment of the present invention will be described with reference to the drawings.

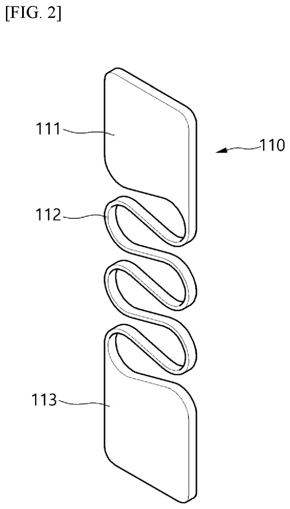

The rubber socket apparatus for testing circuits of an electronic device according to one embodiment of the present invention may include a plurality of test pins, a lower film 120, an upper film 130 and a rubber layer 140, as shown in FIGS. 2 to 4.

The plurality of test pins may be MEMS pins 110. Certainly, other existing metal pins may be applied.

In this case, a plurality of test pins may be arranged so as to be able to test circuits of an electronic device. The plurality of test pins may be arranged so as to be parallel to the rubber layer 140.

The MEMS pin 110, referring to FIG. 2, may be provided with an upper body 111, a lower body 113 and an elastic connection portion 112 configured to connect the upper body 111 and the lower body 113.

In this case, the MEMS pin 110 may be manufactured by a semiconductor Micro Electro Mechanical Systems (MEMS) process.

In this case, the MEMS pin 110 may include an upper body 111, a lower body 113 and an elastic connection portion 112 configured to connect the two, and generally, the upper body 111, the lower body 113 and the elastic connection portion 112 may be formed integrally.

In this case, the upper body 111 and the lower body 113 may have a square shape when viewed from the front, but are not limited to such a shape. That is, the upper part of the upper body 111 comes into contact with a terminal, and may have various shapes such as a straight line, a concave or convex protrusion and a tooth shape.

In this case, the upper body 111 and the lower body 113 may be installed and fixed so as to penetrate through through-holes 120a, 130a formed in films 120, 130, respectively. In this way, a rubber layer 140 may be formed while the upper body 111 and the lower body 113 are each fixed.

In this case, the elastic connection portion 112 is formed in a zigzag shape but has a smooth curved shape overall. Therefore, when an external force that pulls or compresses is applied between the upper body 111 and the lower body 113, an elastic force may be provided in the opposite direction, and when the external force is removed, it may return to its original length state.

In this case, the upper end of the upper body 111 may be formed so as to protrude from the rubber layer 140 or the upper film 130. Referring to FIG. 2, the upper end of the upper body 111 may be installed so as to protrude from the upper film 130.

In this way, the upper body 111 may be formed such that it protrudes from the upper film 130, and the lower body 113 may be formed such that an end thereof is aligned with the lower film 120a. This can be achieved by the arrangement and shape of a jig when manufacturing a socket, and when the upper and lower bodies 111, 113 are disposed and fixed in this way, a testing device that supplies current to test will be arranged on the lower side, and an electronic device that is a test target will be arranged on the upper side.

In this case, the upper body 130 of the MEMS pin 110 may be formed in any one shape selected from S-shape, C-shape, cross-shape and gantry-shape, so as to be able to make contact with a test terminal of the electronic device over a wider range. By being formed in this way, the contactable area may be increased, thereby reducing connection failure.

The rubber layer 140 may have a plurality of test pins held upright and embedded therein.

In this case, the rubber layer 140 may be made of silicone rubber.

In this case, the rubber layer 140 through which the plurality of test pins penetrate may be empty and not supplied with a rubber material.

In this case, the rubber layer 140 through which the plurality of test pins penetrate may be filled with a softer rubber material than other parts.

In this case, the rubber layer 140 in which the lower body 113 and the upper body 111 of the MEMS pin 110 are arranged may be filled with different rubber materials, but the rubber material filled in the upper body 111 may be softer than the rubber material filled in the lower body 113.

In this case, since the elastic connection portion 112 of the MEMS pin 110 is not provided with a rubber material, an air layer may be formed.

In the illustrated embodiment, various shapes may be provided as needed for a contact part between the rubber layer 140 and the plurality of test pins as described above.

In this case, an upper film 130 and a lower film 120 are respectively bonded to upper and lower parts of the rubber layer 140, and any one of the upper film 130 and the lower film 120 may be the shielding film.

That is, the shielding film may be adhered to any one surface of the upper or lower surface of the rubber layer 140 for shielding or signal noise reduction.

In this case, the shielding film may be a copper-plated film or a film embedded with a copper layer.

In this case, the shielding film may be an FR4 laminate film plated with copper or may include a copper film internally.

In this case, any one of the plurality of test films is a ground pin 110a, and the ground pin 110a is electrically connected to a copper plating or copper film of the shielding film to remove signal noise.

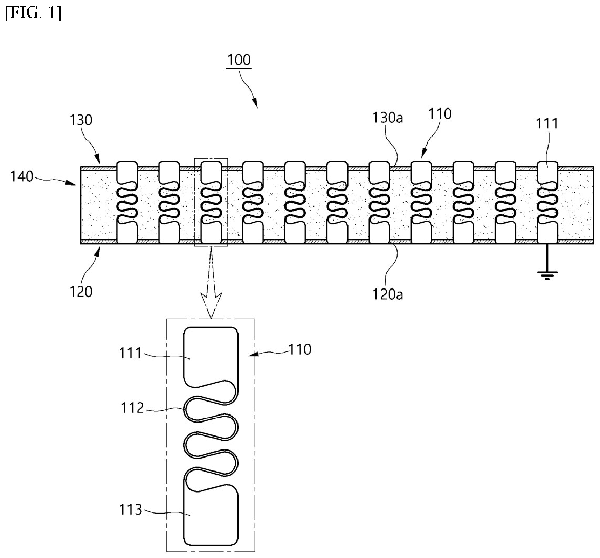

Referring to FIG. 1, the cross-sectional view of a rubber socket apparatus 100 for testing circuits of an electronic device according to one embodiment of the present invention is illustrated.

In the illustrated embodiment, an upper film 130 and a lower film 120 are attached to the upper and lower parts of the rubber layer 140, and MEMS pins 110 are installed at regular intervals to penetrate the rubber layer 140, the upper film 130 and the lower film 120.

In the illustrated embodiment, the rubber layer 140 is made of a flexible material to ensure flexibility, and the MEMS pin 110 may be secured in flexibility by the elastic connection portion 112. Therefore, when the rubber socket apparatus 100 for testing circuits of an electronic device is connected to a testing target and testing equipment, the overall flexibility is secured, thereby improving the connection reliability.

In the illustrated embodiment, an upper film 130 and a lower film 120 are conventionally disposed on a jig or the like, and MEMS pins 110 are disposed by holding up on the upper film 130 and the lower film 120, and then, silicone rubber is poured and hardened to manufacture a rubber socket apparatus 100 for testing circuits of an electronic device.

In the illustrated embodiment, in addition to the manufacturing method described above, a rubber layer 140 may be first manufactured, holes 120a, 130a may be drilled to insert MEMS pins 110, and then, an upper film 130 or a lower film 120 may be attached as a shielding film.

Accordingly, depending on the manufacturing method, the rubber layer 140 may be divided into several layers as described above and manufactured with different soft or hard properties, and it is also possible to fill the inside of the holes 120a, 130a into which the MEMS pin 110 is inserted with an air layer or rubber material.

In the illustrated embodiment, one of the MEMS pins 110 is a ground pin 110a and it is in a grounded state along a ground line.

Referring to FIG. 2, the perspective view of a MEMS pin, which is a partial component of a rubber socket apparatus for testing circuits of an electronic device according to one embodiment of the present invention, is illustrated.

In the illustrated embodiment, the MEMS pin 110 may include an upper body 111, a lower body 113 and an elastic connection portion 112 configured to elastically connect the upper body 111 and the lower body 113. Here, the upper body 111, the elastic connection portion 112 and the lower body 113 may be formed integrally and may be formed in a thin plate shape.

In the illustrated embodiment, when the MEMS pin 110 receives force from the upper and lower parts, the elastic connection portion 112 is compressed and elastically returns to its original position, thereby providing an elastic force. In addition, when any one body receives force in the left and right direction based on the lower body 120 or the upper body 111, it also easily bends left and right, and when the external force is removed, it returns to its original position.

Accordingly, since the MEMS pin 110 can be flexibly compressed and bent when it is subjected to force in all three directions, like the rubber layer 140, and can return to its original position, the rubber socket apparatus 100 may respond to testing with very flexible behavior and posture as a whole. This provides flexibility that can sufficiently respond to manufacturing errors of electronic devices and testing equipment during testing.

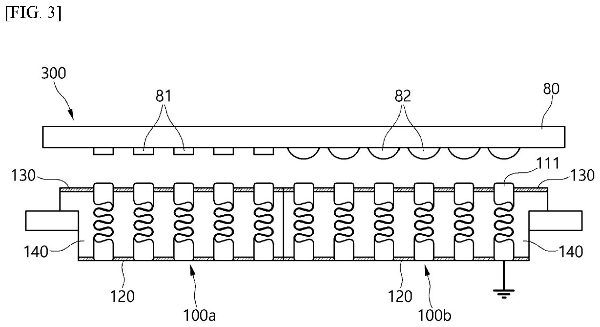

Referring to FIG. 3, a cross-sectional view is illustrated showing a state before the testing of a rubber socket apparatus for testing circuits of an electronic device according to one embodiment of the present invention is performed.

In the illustrated embodiment, an electronic device 300 may be disposed and connected on the upper side of the rubber socket apparatus 100, and testing equipment may be disposed and connected on the lower side.

In this case, the electronic device disposed on the upper side, which is a testing target, may be of different types. For example, a terminal 81 on the left side of the electronic device 300 is of the LGA type, and a terminal 82 on the right side is of the BGA type. Therefore, there are various types of terminals of the electronic device 300, and the heights of the terminals are also different depending on the type. In this state, when the electronic device 300 is connected to the rubber layer 140 and pressed, since the rubber socket apparatus 100 is very flexible, all terminals 81, 82 and the MEMS pins 110 are smoothly connected.

That is, referring to FIG. 3, a left part 100a of the rubber socket apparatus 100 is connected to a low-height terminal 81, and a right part 100b is connected to a high-height terminal 82, resulting in a height difference. However, the flexibility of the rubber layer 140 and the MEMS pin 110 can overcome this and ensure smooth connection.

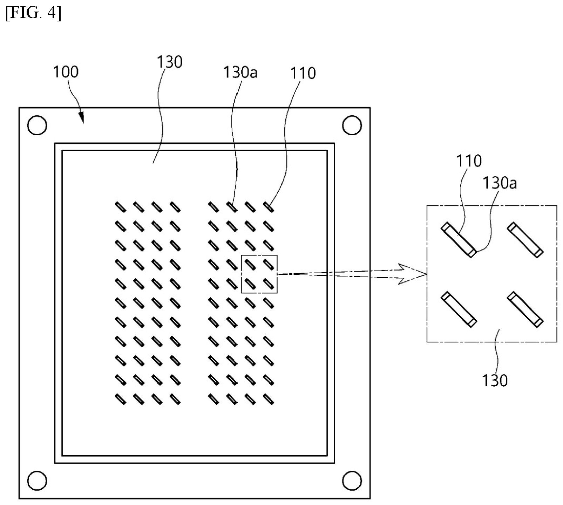

Referring to FIG. 4, the plan view of a rubber socket apparatus for testing circuits of an electronic device according to one embodiment of the present invention is illustrated.

In the illustrated embodiment, the rubber socket apparatus 100 is approximately rectangular in a plan view. The upper film 130 is a shielding film. A plurality of through-holes 130a are formed in a diagonal direction in the upper film 130, and the upper body 111 of the MEMS pin 110 protrudes and is exposed in the through-holes 130a. Certainly, the lower film may be made of a shielding film and have the same structure.

In the illustrated embodiment, the MEMS pins 110 are disposed in an 8*12 form on one rubber layer 140, and an electronic device and testing equipment will be connected to the upper and lower parts of the rubber layer 140, respectively.

In the illustrated embodiment, any one film of the upper film 130 and the lower film 120 is made of a shielding film made of a copper-plated film or an FR4 film embedded with a copper layer, and since one of the MEMS pins 110 is a ground pin 110a, signal noise may be removed during testing an electronic device, thereby minimizing testing defects.

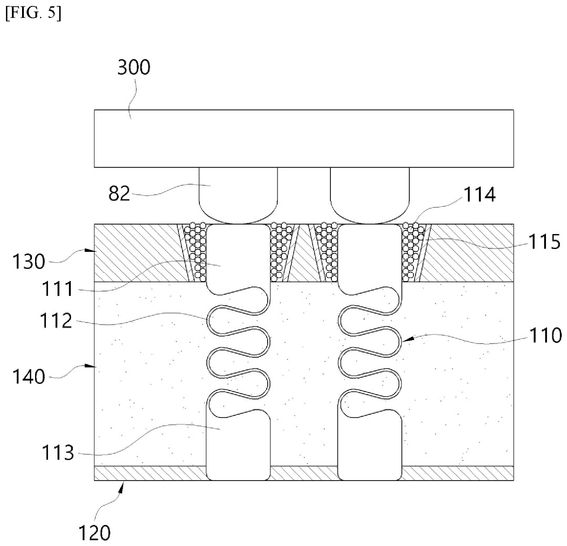

Meanwhile, referring to FIG. 5, the partially enlarged cross-sectional view of a socket apparatus for testing circuits of an electronic device according to another embodiment of the present invention is illustrated.

In the illustrated embodiment, a plurality of MEMS pins 110 are held up and embedded in the rubber layer 140. The MEMS pin 110 is composed of an upper body 111 and a lower body 113 like a typical MEMS pin 110, and includes an elastic connection portion 112 configured to connect the same. The MEMS pin 110 may be formed in a thin plate shape, as in the above-described embodiment.

In this case, an upper film 111 and a lower film 113 are installed on the upper and lower ends of the rubber layer 140, respectively.

In this case, since the MEMS pin 110 is embedded by penetrating through the upper and lower films 111, 113 and the rubber layer 140, a through-hole 115 is formed in each.

In this case, the through-hole 115 of the upper film 130 is formed in a tapered shape and is spaced apart from the upper body 111, and a metal powder layer 114 is installed therebetween to surround the upper body 111.

Therefore, the testing current may flow through the upper body 111, the metal powder layer 114, the elastic connection portion 112 and the lower body 113.

In FIG. 3, the terminal 82 of a testing object 300 is a BGA-type terminal. In the illustrated embodiment, since the terminal 82 is in contact with the upper body 111, testing current may flow.

In this case, since the upper body 111 is thin, there may be cases where it is separated from the terminal 82 and does not make contact. In this case, since the terminal 82 is in contact with the metal powder layer 114, the testing current may eventually flow through the upper body 111, the elastic connection portion 112 and the lower body 113.

Here, since the through-hole 115 is formed in a tapered shape and the area of the upper end part of the metal powder layer 141 is larger than that of the lower part, electrical contact may be made over a wide area, thereby preventing testing defects due to non-contact through a stable flow of testing current.

Although the embodiments of the present invention have been described, the concept of the present invention is not limited to the embodiments presented in the present specification, and those skilled in the art who understand the concept of the present invention will be able to easily propose other embodiments by adding, changing, deleting or supplementing components within the scope of the same concept, but this will also be considered to fall within the spirit of the present invention.

### INDUSTRIAL APPLICABILITY

The present invention can be applied to the testing of semiconductor devices, which are microscopic electronic components.

## Claims

1. A rubber socket apparatus for testing circuits of an electronic device, comprising:
a plurality of test pins aligned such that circuits of an electronic device are tested;
a rubber layer in which the plurality of test pins are embedded upright; and
a shielding film that is in close contact with any one surface of an upper surface or a lower surface of the rubber layer for shielding or signal noise reduction.

2. The rubber socket apparatus of claim 1, wherein an upper film and a lower film are bonded to upper and lower parts of the rubber layer, respectively, and any one of the upper film or the lower film is the shielding film.

3. The rubber socket apparatus of claim 1, wherein the shielding film is a copper-plated film or a film embedded with a copper layer.

4. The rubber socket apparatus of claim 1, wherein the plurality of test pins are MEMS pins having an upper body, a lower body and an elastic connection portion configured to connect the upper body and the lower body.

5. The rubber socket apparatus of claim 1, wherein a rubber layer that is penetrated by the plurality of test pins is not supplied with a rubber material and remains empty.

6. The rubber socket apparatus of claim 1, wherein a rubber layer that is penetrated by the plurality of test pins is filled with a softer rubber material than other parts.

7. The rubber socket apparatus of claim 4, wherein a rubber layer in which a lower body and an upper body of the MEMS pin are disposed is filled with different rubber materials, wherein a rubber material filled in the upper body is softer than a rubber material filled in the lower body.

8. The rubber socket apparatus of claim 4, wherein an elastic connection portion of the MEMS pin is not provided with a rubber material and is formed with an air layer.

9. The rubber socket apparatus of claim 1, wherein the shielding film is made of an FR4 laminate film plated with copper or comprises a copper film internally.

10. The rubber socket apparatus of claim 1, wherein the rubber layer is made of a silicone rubber.

11. The rubber socket apparatus of claim 1, wherein among the plurality of test pins, any one is a ground pin, and the ground pin is electrically connected to a copper plating or a copper film of the shielding film to remove signal noise.
